# EUROPEAN PATENT APPLICATION

(11) **EP 3 093 319 A1**
(43) Date of publication of application: **16.11.2016**
(21) Application number: 15167478.5
(22) Date of filing: 13.05.2015
(51) Int. Cl.: C09D 163/00, C09J 9/02, C09J 11/04, H01B 1/22, H05K 3/32, C09J 163/00

(54) **ELECTRICALLY CONDUCTIVE COMPOSITION**

(71) Applicant: Heraeus Deutschland GmbH & Co. KG, 63450 Hanau (DE)
(72) Inventor: Schmitt, Wolfgang, 63110 RODGAU (DE); Dickel, Tanja, 63543 NEUBERG (DE)
(74) Representative: Heraeus IP

(57) **Abstract**

An electrically conductive composition comprising
(A) 20 to 45 vol.-% of electrically conductive particles,
(B) 0 to 10 vol.-% of non-metallic particles,
(C) 50 to 75 vol.-% of a curable resin system,
(D) 0.05 to 10 vol.-% of at least one compound selected from the group consisting of metal oxides, metal hydroxides and metal salts of C₁-C₁₈-carboxylic acids, wherein the metal is selected from the group consisting of copper, zinc and tin, and
(E) 0 to 10 vol.-% of at

## Description

The present invention relates to an electrically conductive composition which can be used as an electrically conductive adhesive composition, in particular in electronics and microelectronics applications. It can be used especially in such electronics and microelectronics applications where components and/or substrates having a tin contact surface need to be mechanically and electrically connected to one another via such tin contact surface by adhesive bonding.

In the preceding paragraph the terms "electronics" and "microelectronics" are used. In the following description and in the claims the term "electronics" will be used for short. It shall include "microelectronics" as well.

In the description and in the claims the terms "component" and "substrate" are used. From the context the skilled person will understand that these terms mean in particular electronic components and substrates, which will be explained below in more detail.

In the description and in the claims the term "tin contact surface" is used. It shall include "tinned contact surface" such as "tin-plated contact surface" or "tin-coated contact surface" as well. Hence, the term "tin contact surface" used herein means a component's or a substrate's outer tin surface serving as the component's or substrate's contact surface.

Electronic devices require electrically conductive connections between substrates and active and/or passive components. Such devices are used for example in communication (e.g. mobile phones, tablets and computers), power conversion (e.g. power electronic modules) or the like. There are numerous requirements for a conductive adhesive to meet in these applications. Besides high mechanical stability (adhesive power expressed as shear strength) and high electrical and thermal conductivity and compatibility with a wide range of substrates are required.

Examples of the afore mentioned substrates include lead frames, PCB (printed circuit boards), flexible electronics, ceramic substrates, IMS (insulated metal substrate) and the like.

Examples of the afore mentioned components include diodes, LEDs (light emitting diodes), dies, IGBTs (insulated gate bipolar transistors), ICs (integrated circuits), sensors, connecting elements (e.g. clips), heat sinks, resistors, capacitors, inductors and antennae.

It is quite common that such components and substrates have a solderable tin contact surface, which allows for solder connecting said parts.

It is possible to fix a component to a substrate via a tin contact surface of the electronic component or of the substrate or, if both have a tin contact surface, via their tin contact surfaces by way of a conventional electrically conductive adhesive composition. However, for unknown reasons, such adhesive bond towards a tin contact surface or between two tin contact surfaces weakens over time, in particular after the adhesive bond has undergone a certain number of temperature changes. Such temperature changes can be simulated in the lab by conventional temperature cycling tests (TCT).

So far the afore mentioned problem has been solved by using components and substrates having contact surfaces of other materials than tin, for example, silver, nickel, gold or copper. However, not least for cost reasons, it is desirable to work with components and/or substrates of the tin contact surface type, independent of the fixing process, i.e. solder fixing or adhesive bonding.

Hence, there is a desire to provide an electrically conductive adhesive composition improved in its long-term bonding strength (long-term adhesion) with regard to adhesive bonding of components having a tin contact surface and/or substrates having a tin contact surface, in particular if such components and/or substrates will undergo temperature changes during their service life.

The invention relates to an electrically conductive composition comprising or consisting of
(A) 20 to 45 vol.-% of electrically conductive particles,
(B) 0 to 10 vol.-% of non-metallic particles,
(C) 50 to 75 vol.-% of a curable resin system,
(D) 0.05 to 10 vol.-% of at least one compound selected from the group consisting of metal oxides, metal hydroxides and metal salts of C₁-C₁₈-carboxylic acids, wherein the metal is selected from the group consisting of copper, zinc and tin, and
(E) 0 to 10 vol.-% of at least one additive.

This disclosure distinguishes between different components with designations (A), (B), (C), (D) and (E), i.e. any substance or material belonging to a category of these components cannot at the same time also belong to another category of said components.

In an embodiment, the sum of the vol.-% of (A), (C), (D) and, if present, (B) and/or (E) may total 100 vol.-% of the electrically conductive composition, i.e. the electrically conductive composition may consist of (A), (C), (D) and, if present, (B) and/or (E).

The vol.-% disclosed in the description and the claims refer to the electrically conductive composition of the invention, i.e. not yet cured, or, to be even more precise, to the electrically conductive composition prior to its use or application.

The electrically conductive composition of the invention comprises 20 to 45 vol.-%, preferably 25 to 40 vol.-% and most preferably 30 to 40 vol.-% of electrically conductive particles (A).

The electrically conductive composition of the invention may comprise one type of particles (A) or a combination of two or more different types of particles (A). For example, the electrically conductive composition of the invention may comprise one type of metal (alloy) particles (A) or a combination of different types of metal (alloy) particles (A).

A first group of electrically conductive particles (A) includes particles of a metal (alloy). The term "particles of a metal (alloy)" used herein shall mean particles of pure metal (purity of ≥ 99 weight-%) and/or of metal alloy. The metal or metal alloy has an electrical conductivity of, for example, > 10⁷ S/m. Examples of useful metal (alloy) particles include silver (alloy) particles, gold (alloy) particles, aluminum (alloy) particles and copper (alloy) particles.

A second group of electrically conductive particles (A) includes particles which are coated with a metal, in particular with a metal having an electrical conductivity > 10⁷ S/m. Examples include metal coated metal particles, e.g. silver coated copper particles and metal coated glass particles, e.g. silver coated glass particles.

The electrically conductive particles (A) may have any shape. Flakes and spherical particles are preferred. The average particle size (d50) of the electrically conductive particles (A) lies in the range of, for example, 1 to 15 µm.

In the description and the claims the term "average particle size" is used. It shall mean the average primary particle size (mean particle diameter, d₅₀) determined by means of laser diffraction. Laser diffraction measurements can be carried out making use of a particle size analyzer, for example, a Mastersizer 3000 from Malvern Instruments.

Particles of type (A) are commercially available. Examples of such particles include NZS-610, SF-3, SF-3J from Ames Goldsmith; TSC-10F20A, TSC-10F20B, TSC-10F20C from Chang Sung; Silver Flake #80, EG-ED-SF from Ferro; RA-0101, P 543-14, P408-4, P582-5, AA-192N from Metalor.

The electrically conductive composition of the invention comprises 0 to 10 vol.-%, preferably 0 to 2 vol.-% of non-metallic particles (B).

The electrically conductive composition of the invention may comprise one type of particles (B) or a combination of two or more different types of particles (B).

The average particle size of the non-metallic particles (B) lies in the range of, for example 1 to 25 µm, preferably 1 to 20 µm, most preferably 1 to 15 µm.

Examples of useful particles of the (B) type include graphite particles and electrically non-conductive non-metallic particles. The term "electrically non-conductive non-metallic particles" used herein shall mean non-metallic particles of a material having an electrical conductivity of < 10⁻⁵ S/m. Examples of such materials include glass, ceramics, plastics, diamond, boron nitride, silicon dioxide, silicon nitride, silicon carbide, aluminosilicate, aluminum oxide, aluminum nitride, zirconium oxide and titanium dioxide.

Particles of type (B) are commercially available. Examples include AE9104 from Admatechs; EDM99,5 from AMG Mining; CL4400, CL3000SG from Almatis; Glass Spheres from Sigma Aldrich; and Spheromers® CA6, CA10, CA15 from Microbeads®.

The electrically conductive composition of the invention comprises 50 to 75 vol.-%, preferably 55 to 70 vol.-% and most preferably 60 to 70 vol.-% of a curable resin system (C).

The curable resin system (C) comprises those constituents of the electrically conductive composition of the invention which after the application and curing thereof form a covalently crosslinked polymer matrix in which the (A) and, if present, (B) particles are embedded.

Curable resin system means a resin system comprising at least one self-crosslinkable resin, typically, in combination with a starter or initiator, and/or one or more crosslinkable resins in combination with one or more hardeners (crosslinkers, curing agents) for the one or more crosslinkable resins. However, the presence of non-reactive resins within such curable resin system is also possible.

To avoid misunderstandings, the term "resin system", although generally understood as referring to polymeric materials, shall not be understood as excluding the optional presence of oligomeric materials. Oligomeric materials may include reactive thinners (reactive diluents). The border between oligomeric and polymeric materials is defined by the weight average molar mass determined by gel permeation chromatography (GPC; divinylbenzene-crosslinked polystyrene as the immobile phase, tetrahydrofuran as the liquid phase, polystyrene standards). Oligomeric materials may have a weight average molar mass of, for example, ≤ 500, while the weight average molar mass of polymeric materials is typically, for example, > 500.

Typically, the constituents of the curable resin system (C) are non-volatile; however, volatile compounds which can be involved in the curing mechanism of the curable resin system may also be present.

The curable resin system (C) is curable by formation of covalent bonds. Covalent bond forming curing reactions may be free-radical polymerization, condensation and/or addition reactions, wherein condensation reactions are less preferred.

As has already been mentioned before, the curable resin system (C) comprises those constituents of the electrically conductive composition of the invention which after the application and curing thereof form a covalently crosslinked polymer matrix or polymer network. This polymer matrix may be of any type, i.e. it may comprise one or more polymers or one or more hybrids of two or more different polymers. Examples of possible polymers may include (meth)acryl copolymers, polyesters, polyurethanes, polysiloxanes, polyethers, epoxy-amine-polyadducts and any combinations. The polymers forming said polymer matrix can stem from polymeric components of the curable resin system (C) and/or can be formed during polymer forming curing reactions of the curable resin system (C) after application and during curing of the electrically conductive composition of the invention.

Hence, the one or more resins which may be constituents of the curable resin system (C) may be selected from, for example, (meth)acryl copolymer resins, polyester resins, polyurethane resins, polysiloxane resins, polyether resins including epoxy resin type polyether resins, epoxy-amine-polyadducts and hybrids thereof.

Self-crosslinkable resins of the curable resin system (C) may be resins carrying functional groups capable of reacting among themselves under formation of covalent bonds in the sense of crosslinked network formation. In the alternative, self-crosslinkable resins are resins carrying different functional groups (F1) and (F2) in one and the same molecule, wherein the functional groups (F2) exhibit a reactive functionality complementary to the functionality of the functional groups (F1). The combination of a crosslinkable resin with a hardener means that the crosslinkable resin carries functional groups (F1), while the hardener carries other functional groups (F2) exhibiting a reactive functionality complementary to the functionality of the functional groups (F1). Examples of such complementary functionalities (F1)/(F2) are:
carboxyl/epoxy, hydroxyl/isocyanate, epoxy/amine, free-radically polymerizable olefinic double bond/free-radically polymerizable olefinic double bond and the like.

The reaction of the complementary functionalities (F1)/(F2) leads in any case to the formation of covalent bonds with the result of formation of a covalently crosslinked polymer network.

In a preferred embodiment, the curable resin system (C) comprises a self-crosslinkable epoxy resin or a system of epoxy resin and hardener for the epoxy resin selected among polyamine hardeners, polycarboxylic acid hardeners and polycarboxylic acid anhydride hardeners. The system of epoxy resin and polyamine hardener for the epoxy resin may optionally comprise lactone.

A curable resin system (C) comprising a self-crosslinkable epoxy resin may comprise a starter or an initiator. It may be a cationic curable system. To initiate cationic cure it requires a cationic initiator, which may be thermo- or UV-labile.

Hence a cationically curable resin system (C) comprising a self-crosslinkable epoxy resin may be a thermally curable or a UV-curable resin system.

Examples of useful epoxy resins are bisphenol A and/or bisphenol F epoxy resins, novolac epoxy resins, aliphatic epoxy resins and cycloaliphatic epoxy resins. Examples of such commercially available epoxy resins include Araldite® GY 279, Araldite® GY 891, Araldite® PY 302-2, Araldite® PY 3483, Araldite® GY 281 and Quatrex® 1010 from Huntsman; D.E.R.™ 331, D.E.R.™ 732, D.E.R.™ 354 and D.E.N™ 431 from Dow Chemical; JER YX8000 from Mitsubishi Chemical; and EPONEX™ Resin 1510 from Momentive Specialty Chemicals.

Examples of useful polyamine hardeners may comprise ≥ 1 primary or secondary amino group per molecule. Typical examples are diamines, triamines and other polyamines with at least two amino groups in the molecule, wherein the amino groups are selected among primary and secondary amino groups. Secondary amino groups can be present as lateral or terminal functional groups or as member of a heterocyclic ring. Examples of polyamine hardeners include diethylenetriamine, ethylenediamine, triethylenetetramine, aminoethylpiperazine, Jeffamine® D230 from Huntsman and heterocyclic polyamine hardeners like imidazole derivatives.

Examples of useful polycarboxylic acid hardeners include methylhexahydrophthalic acid and their possible anhydrides.

Examples of useful lactones are delta-valerolactone, delta-hexalactone, delta-nonalactone, delta-decalactone, delta-undecalactone, gamma-butyrolactone, gamma-hexalactone, gamma-heptalactone, gamma-octalactone, epsilon-caprolactone, epsilon-octalactone, epsilon-nonalactone and mixtures thereof.

The electrically conductive composition of the invention comprises 0.05 to 10 vol.-%, preferably 0.1 to 5 vol.-% and most preferably 0.5 to 2 vol.-% of at least one compound (D) selected from the group consisting of metal oxides, metal hydroxides and metal salts of C₁-C₁₈-carboxylic acids, wherein the metal is selected from the group consisting of copper, zinc and tin. Copper oxide includes Cu₂O and CuO; tin oxide includes SnO and SnO₂. "Metal salts of C₁-C₁₈- carboxylic acids" means copper, zinc and tin salts of C₁-C₁₈-carboxylic acids, examples of which include the corresponding formates, acetates and stearates to name just a few. The compound or compounds (D) may comprise one or more particulate compounds which are insoluble in the (C) matrix. The average particle size of particulate compounds of the (D) type lies in the range of, for example, 1 to 25 µm, preferably 1 to 15 µm and most preferably 1 to 10 µm. Such particulate compounds are present in homogeneously dispersed form within the (C) matrix, just like in the case of the (A) and, if present, (B) particles. However, it is also possible that the at least one compound (D) may comprise one or more compounds which are soluble in the (C) matrix with the consequence that such compounds dissolve homogeneously therein.

The electrically conductive composition of the invention comprises 0 to 10 vol.-% of at least one additive (E). Examples of additives (E) include 1,4-cyclohexanedimethanol divinylether, organic solvents, for example, isopropanol, terpineol, wetting agents, for example, oleic acid, rheological modifiers, for example, nanosized silica, ethylcellulose. The electrically conductive composition of the invention can be made by mixing components (A), (C), (D) and, if present, (B) and/or (E), wherein it is preferred to introduce component (C) first before adding components (A), (D) and, if present, (B) and/or (E). After completion of the mixing the so-produced electrically conductive composition of the invention can be stored until its use or application. It may be advantageous to store the electrically conductive composition of the invention at low temperatures of, for example, -78 to +8 °C.

Dependent on the chemical nature of the (C) component and if desired or expedient, it is also possible to split component (C) into sub-components, for example, into a curable resin sub-component (C1) and a hardener sub-component (C2) and to mix (A), (C1), (D) and, if present, (B) and/or (E) and store that mixture separately from (C2). In so doing a two-component type of electrically conductive composition of the invention is obtained. Its two components are stored separately from each other until use or application of the electrically conductive composition of the invention. The two components are then mixed shortly or immediately before the application.

The electrically conductive composition of the invention can be used as an electrically conductive adhesive composition, in particular in electronics applications. To this end, the electrically conductive composition of the invention is applied to the contact surface of a part to be adhesively bonded to another. Examples of such parts are the above mentioned substrates and components. As has already been mentioned, it has shown that the electrically conductive composition of the invention has a special advantage if at least one of the parts to be adhesively bonded to another (i.e. component and/or substrate) has a tin contact surface.

Application of the electrically conductive composition of the invention may be performed, for example, by printing, e.g. screen printing or stencil printing, by jetting or by dispensing. The typical thickness of the applied and uncured electrically conductive composition of the invention lies in the range of, for example, 5 to 50 µm.

After the application a drying step may be performed in order to remove eventually present volatile compounds like, for example, organic solvent. If such drying step is performed the drying parameters are for example, 1 to 120 minutes at an object temperature of, for example, 60 to 160 °C.

After the application and the optional drying the other part to be adhesively bonded is put with its contact surface onto the layer of electrically conductive adhesive. The so formed assembly consisting of said parts with the layer of the electrically conductive composition in between is then cured. Curing may be initiated by UV irradiation if at least one of the parts to be adhesively bonded is transparent for UV light and if the curing chemistry of the (C) system allows for an UV curing. Examples of UV-curable (C) systems are the already mentioned curable resin system (C) comprising a self-crosslinkable epoxy resin and a UV-labile cationic initiator or a curable resin system (C) comprising free-radically polymerizable components and a UV-labile free-radical initiator.

In the more common alternative of thermal curing heat is applied and the electrically conductive composition or the assembly is heated, for example, for 5 to 30 minutes at an object temperature of, for example, 80 to 160 °C.

A further embodiment of the invention is a hardened composition obtainable by hardening the hardenable electrically conductive composition of the present invention. Therefore, also an assembly, wherein the electrically conductive composition of the present invention is in a hardened state is part of the invention. In other words, a further embodiment of the invention is an assembly comprising a substrate, the hardened electrically conductive composition of the invention and a component. The hardened electrically conductive composition of the invention serves as an electrically conductive adhesive and is therefore located between the substrate and the component, or to be even more precise, between the contact surface of the substrate and that of the component, wherein, in an embodiment, at least one of the contact surfaces is a tin contact surface.

A further embodiment of the invention is the use of the electrically conductive composition of the invention as a hardenable electrically conductive adhesive, in particular in electronics applications, in particular, for the adhesive bonding of a component to a substrate via their contact surfaces, wherein at least one of said contact surfaces is a tin contact surface.

The embodiments and advantages of the invention are further explained by the following non-limiting examples.

### Examples

### Sample preparation and testing:

Electrically conductive adhesive compositions were prepared according to the following general procedure: A mixture of components of type (C) and (E) was made by mixing with a stirrer. Components (A), (B), (D) were added while stirring in the order (A)-(D)-(B). Thereafter a final dispersing step was carried out making use of a three roll mill.

The electrically conductive adhesive compositions so made were printed through a 100 µm stencil a) onto a ceramic substrate (Al₂O₃) and b) onto a tinned contact surface of a PCB FR4 substrate. Thereafter, the printed areas were equipped with components (resistors R1206 and capacitors C1206, each having a tinned contact surface). The samples were cured in a box oven at an object temperature of 150 °C for 20 min. Some samples were directly subject to shear tests (according to DIN EN 1465: 2009-07, shear speed: 300 µm/s). Other samples were subject to TCT first and then to shear testing. TCT was done with 100, 500 or 1000 cycles in a two chamber thermocycle oven from Votsch. Each individual TCT cycle was 30min@-40°C / 30min@+150°C for the ceramic substrates and 30min@-40°C / 30min@+125°C for the PCB FR4 substrates. A shear strength > 10 N/mm² is considered reliable and meets customer specifications.

The following tables show electrically conductive adhesive compositions 1 to 13 (all proportions in vol.-%) and test results. All electrically conductive adhesive compositions exhibited sheet resistivities < 1 mΩ·cm.

**Table 1: Examples with particles comprising component (A) and component (D) within the individual particle**

| | Examples | | |
|---|---|---|---|
| | 1 (comparison) | 2 | 3 |
| | | | |
| Araldite® PY 302-2 | 38.76 | 38.76 | 38.76 |
| 2-ethyl-4-methylimidazole | 2.58 | 2.58 | 2.58 |
| ε-caprolactone | 19.34 | 19.34 | 19.34 |
| 1,4-cyclohexanedimethanol divinyl ether | 3.72 | 3.72 | 3.72 |
| Ag flakes EG-ED-SF from Ferro | 35.60 | 0.00 | 12.90 |
| Ag flakes P 532-23 from Metalor (individual flake comprises silver, SnO and CuO) | 0.00 | 35.60 | 22.70 |
| Total | 100.00 | 100.00 | 100.00 |
| | | | |

| Results on Al₂O₃ ceramic substrate | | | |
|---|---|---|---|
| TCT cycles | Shear strength before/after TCT in N/mm² | | |
| 0 | 24^{*)} | 51 | 53 |
| 100 | 8^{*)} | 56 | 34 |
| 1000 | 5^{*)} | 50 | 30 |
| ^{*)} adhesive fracture; all other samples showed cohesive fracture | | | |
| | | | |

| Results on PCB FR4 substrate | | | |
|---|---|---|---|
| TCT cycles | Shear strength before/after TCT in N/mm² | | |
| 0 | 26^{*)} | 52 | 51 |
| 100 | 8^{*)} | 48 | 35 |
| 1000 | 3^{*)} | 46 | 31 |
| ^{*)} adhesive fracture; all other samples showed cohesive fracture | | | |

Samples with electrically conductive adhesives comprising tin and copper oxide showed significantly higher shear strength.

**Table 2: Examples with tin oxide as component (D)**

| | Examples | | | | |
|---|---|---|---|---|---|
| | 1 (comparison) | 4 | 5 | 6 | 7 |
| | | | | | |
| Araldite® PY 302-2 | 38.77 | 37.36 | 38.05 | 38.62 | 38.73 |
| 2-ethyl-4-methylimidazole | 2.58 | 2.49 | 2.53 | 2.57 | 2.58 |
| ε-caprolactone | 19.34 | 18.64 | 18.97 | 19.26 | 19.31 |
| 1,4-cyclohexanedimethanol divinyl ether | 3.71 | 3.58 | 3.64 | 3.70 | 3.71 |
| Ag flakes EG-ED-SF from Ferro | 35.60 | 29.42 | 32.48 | 35.12 | 35.60 |
| SnO | 0.00 | 8.51 | 4.33 | 0.73 | 0.07 |
| Total | 100.00 | 100.00 | 100.00 | 100.00 | 100.00 |
| | | | | | |

| Results on Al₂O₃ ceramic substrate | | | | | |
|---|---|---|---|---|---|
| TCT cycles | Shear strength before/after TCT in N/mm² | | | | |
| 0 | 24^{*)} | 52 | 22 | 20 | 27 |
| 100 | 12^{*)} | 54 | 38 | 37 | 32 |
| 500 | 6^{*)} | 41 | 33 | 35 | 35 |
| ^{*)} adhesive fracture, all other samples showed cohesive fracture | | | | | |
| | | | | | |

| Results on PCB FR4 substrate | | | | | |
|---|---|---|---|---|---|
| TCT cycles | Shear strength before/after TCT in N/mm² | | | | |
| 0 | 24^{*)} | 49 | 25 | 23 | 29 |
| 100 | 12^{*)} | 50 | 38 | 33 | 31 |
| 500 | 6^{*)} | 41 | 32 | 35 | 32 |
| ^{*)} adhesive fracture, all other samples showed cohesive fracture | | | | | |

Samples with electrically conductive adhesives comprising tin oxide showed significantly higher shear strength, even at a low content of SnO.

**Table 3: Examples with copper oxide as component (D)**

| | Examples | | | |
|---|---|---|---|---|
| | 1 (comparison) | 8 | 9 | 10 |
| Araldite® PY 302-2 | 38.77 | 38.69 | 38.71 | 38.73 |
| 2-ethyl-4-methylimidazole | 2.58 | 2.57 | 2.58 | 2.58 |
| ε-caprolactone | 19.34 | 19.31 | 19.31 | 19.31 |
| 1,4-cyclohexanedimethanol divinyl ether | 3.71 | 3.71 | 3.71 | 3.71 |
| Ag flakes EG-ED-SF from Ferro | 35.60 | 35.45 | 35.55 | 35.60 |
| CuO | 0.00 | 0.27 | 0.14 | 0.07 |
| Total | 100.00 | 100.00 | 100.00 | 100.00 |
| | | | | |

| Results on Al₂O₃ ceramic substrate | | | | |
|---|---|---|---|---|
| TCT cycles | Shear strength before/after TCT in N/mm² | | | |
| 0 | 24^{*)} | 50 | 23 | 28 |
| 100 | 12^{*)} | 44 | 37 | 29 |
| 500 | 6^{*)} | 46 | 38 | 31 |
| ^{*)} adhesive fracture, all other samples showed cohesive fracture | | | | |
| | | | | |

| Results on PCB FR4 substrate | | | | |
|---|---|---|---|---|
| TCT cycles | Shear strength before/after TCT in N/mm² | | | |
| 0 | 24^{*)} | 53 | 21 | 29 |
| 100 | 12^{*)} | 44 | 37 | 29 |
| 500 | 6^{*)} | 46 | 39 | 31 |
| ^{*)} adhesive fracture, all other samples showed cohesive fracture | | | | |

Samples with electrically conductive adhesives comprising copper oxide showed significantly higher shear strength, even at a low content of CuO.

**Table 4: Examples with tin oxide, copper oxide, tin acetate or copper hydroxide as component (D)**

| | 1 (comparison) | 11 | 12 | 13 |
|---|---|---|---|---|
| | | | | |
| Araldite® PY 302-2 | 38.76 | 37.32 | 38.29 | 38.58 |
| 2-ethyl-4-methylimidazole | 2.58 | 2.48 | 2.55 | 2.57 |
| ε-caprolactone | 19.34 | 18.63 | 19.09 | 19.24 |
| 1,4-cyclohexanedi methanol divinyl ether | 3.72 | 3.58 | 3.67 | 3.70 |
| Ag flakes EG-ED-SF from Ferro | 35.60 | 29.23 | 35.04 | 35.30 |
| SnO | 0.00 | 8.50 | 0.00 | 0.00 |
| CuO | 0.00 | 0.26 | 0.00 | 0.00 |
| Sn(IV)acetate | 0.00 | 0.00 | 1.36 | 0.00 |
| Cu(II) hydroxide | 0.00 | 0.00 | 0.00 | 0.61 |
| Total | 100.00 | 100.00 | 100.00 | 100.00 |
| | | | | |

| Results on Al₂O₃ ceramic substrate | | | | |
|---|---|---|---|---|
| TCT cycles | Shear strength before/after TCT in N/mm² | | | |
| 0 | 24^{*)} | 56 | 62 | 37 |
| 100 | 12^{*)} | 52 | 53 | 36 |
| 500 | 6^{*)} | 47 | 49 | 28 |
| ^{*)} adhesive fracture, all other samples showed cohesive fracture | | | | |
| | | | | |

| Results on PCB FR4 substrate | | | | |
|---|---|---|---|---|
| TCT cycles | Shear strength before/after TCT in N/mm² | | | |
| 0 | 24^{*)} | 52 | 55 | 33 |
| 100 | 12^{*)} | 52 | 52 | 32 |
| 500 | 6^{*)} | 45 | 49 | 28 |
| ^{*)} adhesive fracture, all other samples showed cohesive fracture | | | | |

## Claims

1. An electrically conductive composition comprising
(A) 20 to 45 vol.-% of electrically conductive particles,
(B) 0 to 10 vol.-% of non-metallic particles,
(C) 50 to 75 vol.-% of a curable resin system,
(D) 0.05 to 10 vol.-% of at least one compound selected from the group consisting of metal oxides, metal hydroxides and metal salts of C₁-C₁₈-carboxylic acids, wherein the metal is selected from the group consisting of copper, zinc and tin, and
(E) 0 to 10 vol.-% of at least one additive.

2. The electrically conductive composition of claim 1,
wherein the sum of the vol.-% of (A), (C), (D) and, if present, (B) and/or (E) totals 100 vol.-%.

3. The electrically conductive composition of claim 1 or 2,
wherein the electrically conductive particles (A) are metal particles and/or metal (alloy) particles, wherein the metal or metal alloy has an electrical conductivity of > 10⁷ S/m.

4. The electrically conductive composition of claim 1, 2 or 3,
wherein the non-metallic particles (B) are graphite particles and/or electrically non-conductive non-metallic particles of a material having an electrical conductivity of < 10⁻⁵ S/m.

5. The electrically conductive composition of any one of the preceding claims,
wherein the curable resin system (C) comprises those constituents of the electrically conductive composition which after the application and curing thereof form a covalently crosslinked polymer matrix in which the (A) and, if present, (B) particles are embedded.

6. The electrically conductive composition of any one of the preceding claims,
wherein the curable resin system (C) comprises self-crosslinkable epoxy resin or a system of epoxy resin and hardener for the epoxy resin selected among polyamine hardeners, polycarboxylic acid hardeners and polycarboxylic acid anhydride hardeners.

7. The electrically conductive composition of claim 6,
wherein the curable resin system (C) comprises a system of epoxy resin, polyamine hardener for the epoxy resin and, optionally, lactone.

8. A hardened electrically conductive composition obtainable by hardening the electrically conductive composition of any one of the preceding claims.

9. An assembly comprising a substrate and a component each of which having a contact surface with the electrically conductive composition of any one of claims 1 to 7 in between.

10. The assembly of claim 9,
wherein the electrically conductive composition is hardened.

11. The assembly of claim 9 or 10,
wherein at least one of the contact surfaces is a tin contact surface.

12. Use of an electrically conductive composition of any one of claims 1 to 7 as a hardenable electrically conductive adhesive.

13. The use of claim 12 in electronics applications.

14. The use of claim 12 for the adhesive bonding of a component having a contact surface to a substrate having a contact surface via said contact surfaces, wherein at least one of the contact surfaces is a tin contact surface.
